# EUROPÄISCHE PATENTANMELDUNG

(11) **EP 1 445 497 A1**
(43) Veröffentlichungstag der Anmeldung: **11.08.2004**
(21) Anmeldenummer: 03028013.5
(22) Anmeldetag: 06.12.2003
(51) Int. Cl.: F16B 19/10, B60R 16/02

(54) **Gehäuse mit Blindniet zum Anbringen an einem Fahrzeugbauteil**

(30) Priorität: 08.02.2003 DE 10305190
(71) Anmelder: DaimlerChrysler AG, 70567 Stuttgart (DE)
(72) Erfinder: Bendlin, Oliver, 76467 Bietigheim (DE); Eilert, Gerd, 71409 Schwaikheim (DE); Schmid, Peter, 75323 Bad Wildbad (DE); Wörner, Frank, 71065 Sindelfingen (DE)

(57) **Zusammenfassung**

Es wird ein Gehäuse (5), insbesondere zur Aufnahme einer Baugruppe mit elektrischen und/oder elektronischen Bauteilen, vorgeschlagen. Das Gehäuse (5) ist mit mindestens einem Blindniet (13,15) zur Befestigung des Gehäuses (5) an einem Fahrzeugbauteil versehen.

## Beschreibung

Die Erfindung betrifft ein Gehäuse, insbesondere zur Aufnahme einer Baugruppe mit elektrischen und/oder elektronischen Bauteilen, gemäß Oberbegriff des Anspruchs 1.

Gehäuse der hier angesprochenen Art sind bekannt (DE 199 56 675 A1). Sie dienen beispielsweise zur Aufnahme von elektrischen und/oder elektronischen Bauteilen eines Sensors oder eines Steuergeräts beziehungsweise einer Steuereinheit. Das Gehäuse wird beispielsweise mittels Schrauben oder Nieten an einem Fahrzeugbauteil befestigt und weist hierzu einen Befestigungsflansch mit einer Durchgangsöffnung auf, in die die Schraube beziehungsweise der Niet eingesteckt wird. Zur Befestigung des Gehäuses an dem Fahrzeugbauteil wird je nach vorgesehener Befestigungsart entweder der Niet oder die Schraube beziehungsweise eine Mutter, die mit einer an einem Fahrzeugbauteil vorgesehenen Schraube verschraubbar ist, manuell angesetzt und mit Hilfe eines geeigneten Werkzeugs vernietet beziehungsweise verschraubt. Diese Art der Montage erfordert eine hohe Fingerfertigkeit. Dabei muss vom Monteur sowohl das Befestigungswerkzeug als auch das Befestigungsmittel an das gegebenenfalls auch manuell in Montageposition gehaltene Gehäuse herangeführt werden.

Es ist Aufgabe der Erfindung, ein Gehäuse der eingangs genannten Art zu schaffen, das schnell und in einfacher Weise am Fahrzeugbauteil montierbar ist.

Zur Lösung der Aufgabe wird ein Gehäuse mit den Merkmalen des Anspruchs 1 vorgeschlagen, das sich dadurch auszeichnet, dass das Gehäuse mit mindestens einem Blindniet versehen ist, wobei der Blindniet zum Befestigen des Gehäuses an einem Fahrzeugbauteil dient. Dadurch, dass das Befestigungsmittel bei der Montage nicht manuell an das Gehäuse herangeführt werden muss, sondern bereits am Gehäuse gehalten beziehungsweise befestigt ist, ist das Anbringen des Gehäuses am Fahrzeugbauteil erheblich vereinfacht. Der Monteur muss hierzu lediglich das Werkzeug zum Vernieten der Blindniet heranführen, was bei üblicher Handhabung mit einer Hand möglich ist und kann -sofern nicht eine Vorfixierung des Gehäuses am Fahrzeugbauteil vorgesehen ist- mit der anderen Hand das Gehäuse in der gewünschten Befestigungsposition halten, bis der Nietvorgang abgeschlossen ist. Die erfindungsgemäße Ausgestaltung des Gehäuses ermöglicht eine einfache, schnell durchführbare und somit kostengünstige Montage des Gehäuses am Fahrzeugbauteil.

Blindnieten sind allgemein bekannt, beispielsweise aus der DE 101 11 404 A1 und der DE 101 62 063 A1, so dass auf deren Aufbau und Funktion hier nicht näher eingegangen wird.

In bevorzugter Ausführungsform ist der mindestens eine Blindniet verliersicher am Gehäuse angebracht. Dies kann beispielsweise dadurch realisiert werden, dass der Blindniet in eine am Gehäuse vorgesehene Aufnahme eingepresst (Kraftschluss) und/oder eingeklebt beziehungsweise eingeschweißt (Stoffschluss) ist. Nach einer anderen Ausführungsvariante ist der Blindniet in das Gehäuse eingespritzt, das heißt, bei der Herstellung des aus Kunststoffmaterial oder Metall bestehenden Gehäuses wird der wenigstens eine Blindniet in die Gehäuseherstellungsform, beispielsweise Spritzgießform, eingebracht und nach der Fertigstellung des Gehäuses durch das Gehäusematerial selbst gehalten.

Weitere vorteilhafte Ausführungsbeispiele des Gehäuses ergeben sich aus Kombinationen der aus den Unteransprüchen hervorgehenden Merkmale.

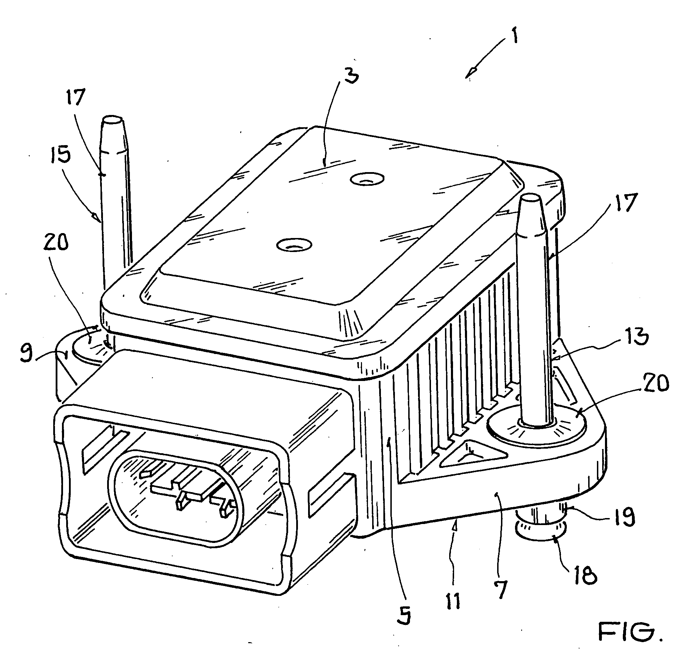

Die Erfindung wird im Folgenden anhand der einzigen Figur näher erläutert. Diese zeigt eine perspektivische Darstellung eines Sensors 1 für Kraftfahrzeuge, der ein mittels eines Deckels 3 verschließbares Gehäuse 5 aufweist. Im Gehäuse 5 sind elektrische und/oder elektronische Bauteile des Sensors untergebracht.

Auf gegenüberliegenden Seiten des Gehäuses 5 sind Befestigungsflansche 7 und 9 vorgesehen, die einstückig mit dem Gehäuse 5 ausgebildet sind. Bei dem in der Figur dargestellten Ausführungsbeispiel bilden die Unterseiten der Befestigungsflansche 7, 9 und der Boden des Gehäuses 5 eine ebene Anlagefläche 11, die im am Fahrzeugbauteil montierten Zustand des Gehäuses 5 in Anlagekontakt mit einer am Fahrzeugbauteil vorgesehenen Gegenfläche steht. An den Befestigungsflanschen 7, 9 ist jeweils ein Blindniet 13 beziehungsweise 15 vorgesehen, die beispielsweise an die Befestigungsflansche 7, 9 an- beziehungsweise eingespritzt sind. Alternativ können die Befestigungsflansche 7, 9 auch mit einer Durchgangsöffnung versehen sein, in die der jeweilige Blindniet eingesteckt ist. Die Blindnieten 13, 15 sind identisch ausgebildet, so dass im Folgenden lediglich der Blindniet 13 näher beschrieben wird.

Der Blindniet 13 umfasst einen Nietdorn 17, einen endseitig daran vorgesehenen Dornkopf 18, eine Niethülse 19 sowie einen Setzkopf 20. In bevorzugter Ausführungsform sind der Nietdorn 17 und der Dornkopf 18 sowie die Niethülse 19 und der Setzkopf 20 jeweils einstückig ausgebildet. Der Nietdorn 17 durchgreift den Setzkopf 20 und die Niethülse 19. Wie aus der Figur ersichtlich, ist die Anordnung des Blindniets 13 am Gehäuse 5 so gewählt, dass der Nietdorn 17 im Wesentlichen senkrecht zur Anlagefläche 11 verläuft. Der Blindniet 13 ist an seiner in den Befestigungsflansch 7 eingespritzten Niethülse 19 am Gehäuse 5 gehalten, wobei die Niethülse 19 und der sich endseitig daran anschließende Dornkopf 18 über die Anlagefläche 11 hervorstehen. Der Setzkopf 20 ist so angeordnet, dass er sich beim Vernieten an der Oberseite des Befestigungsflanschs 7 abstützen kann.

Zum Befestigen des Gehäuses 5 an dem Fahrzeugbauteil, beispielsweise Blechbauteil, insbesondere Fahrzeugkarosserieteil, wird der komplett vormontierte Sensor 1 an das Fahrzeugbauteil herangeführt, wobei die Blindnieten 13, 15 mit ihren über die Anlagefläche 11 hervorstehenden Abschnitten in entsprechende Öffnungen am Fahrzeugbauteil eingeführt werden und zwar soweit, bis die Anlagefläche 11 des Gehäuses 5 in Anlagekontakt mit der Gegenfläche am Fahrzeugbauteil gelangt. Dann werden die Blindnieten 13, 15 mit einem entsprechenden Werkzeug, insbesondere Blindnietzange, das am Nietdorn 17 ansetzt, vernietet. Beim Nietvorgang wird der Nietdorn 17 in Richtung seiner Längsmittelachse so verlagert, dass sich der Dornkopf 18 in Richtung auf die Anlagefläche 11 am Befestigungsflansch bewegt. Dabei wird die Niethülse 19 gestaucht, was zu einer Vergrößerung ihres Außendurchmessers und somit zu einem Festklemmen in der Aufnahme am Fahrzeugbauteil führt. Bei Erreichen einer bestimmten, vordefinierten Zugkraft reißt dann der Nietdorn 17 an einer üblicherweise vorhandenen Sollbruchstelle ab.

Die Blindnieten 13, 15 als Befestigungsmittel für das Gehäuse 5 weisen den Vorteil auf, dass die mit deren Hilfe erzeugten Haltekräfte exakt vorbestimmbar sind und aufgrund des bei einer bestimmten Zugkraft abreißenden Nietdorns 17 nicht überschritten werden können, so dass eine Beschädigung des Fahrzeugbauteils, beispielsweise ein Abplatzen von auf das Fahrzeugbauteil aufgebrachtem Lack, ausgeschlossen werden kann.

## Patentansprüche

1. Gehäuse (5), insbesondere zur Aufnahme einer Baugruppe mit elektrischen und/oder elektronischen Bauteilen,
**dadurch gekennzeichnet,**
**dass** das Gehäuse (5) mit mindestens einem Blindniet (13,15) zur Befestigung des Gehäuses (5) an einem Fahrzeugbauteil versehen ist.

2. Gehäuse nach Anspruch 1,
**dadurch gekennzeichnet,**
**dass** der Blindniet (13,15) verliersicher am Gehäuse (5) angebracht ist.

3. Gehäuse nach Anspruch 1 oder 2,
**dadurch gekennzeichnet,**
**dass** der Blindniet (13,15) mittels Kraftschluss, Formschluss und/oder Stoffschluss mit dem Gehäuse (5) verbunden ist.

4. Gehäuse nach einem der Ansprüche 1 bis 3,
**dadurch gekennzeichnet,**
**dass** der Blindniet (13,15) in das Gehäuse (5) eingespritzt ist.

5. Gehäuse nach einem der Ansprüche 1 bis 4,
**dadurch gekennzeichnet,**
**dass** der Blindniet (13,15) einen Nietdorn (17), eine Niethülse (19), einen Setzkopf (20) sowie einen Dornkopf (18) aufweist, wobei die Niethülse (19) und der Dornkopf (18) im nicht vernieteten Zustand aus einer Anlagefläche (11) des Gehäuses (5) hervorstehen.

6. Gehäuse nach einem der Ansprüche 1 bis 5,
**dadurch gekennzeichnet,**
**dass** das Gehäuse (5) einen Befestigungsflansch (7,9) aufweist, an dem der Blindniet (13,15) gehalten ist.

7. Gehäuse nach Anspruch 6,
**dadurch gekennzeichnet,**
**dass** der Setzkopf (20) an der der Anlagefläche (11) gegenüberliegenden Seite des Befestigungsflanschs (7,9) anliegt.
